# EUROPÄISCHE PATENTANMELDUNG

(11) **EP 1 191 645 A1**
(43) Veröffentlichungstag der Anmeldung: **27.03.2002**
(21) Anmeldenummer: 01122437.5
(22) Anmeldetag: 20.09.2001
(51) Int. Cl.: H01R 13/719, H05K 9/00

(54) **Elektronisches Gerät**

(30) Priorität: 22.09.2000 DE 10047065
(71) Anmelder: SIEMENS AKTIENGESELLSCHAFT, 80333 München (DE)
(72) Erfinder: Busch, Dieter, 61191 Rosbach (DE); Berberich, Reinhold, 60439 Frankfurt (DE)

(57) **Zusammenfassung**

Die Erfindung betrifft ein elektronisches Gerät mit einer an einem elektrisch leitendem Gehäuse befestigten Kontakteinrichtung, welche mindestens ein Steckelement zur elektrischen Kontaktierung einer in dem Gehäuse angeordneten elektrischen Schaltung aufweist, wobei ein Kondensator zur Verbesserung der elektromagnetischen Empfindlichkeit der elektronischen Schaltung vorgesehen ist.

Bei einem auch für die Massenproduktion geeigneten elektronischen Gerät erfolgt eine einfache und billige Entstörmaßnahme dadurch, daß das Steckelement selbst als Kondensator ausgebildet ist.

## Beschreibung

Die Erfindung betrifft ein elektronisches Gerät mit einer an einem elektrisch leitendem Gehäuse befestigten Kontakteinrichtung, welche mindestens ein Steckelement zur elektrischen Kontaktierung einer in dem Gehäuse angeordneten elektrischen Schaltung aufweist, wobei ein Kondensator zur Verbesserung der elektromagnetischen Empfindlichkeit der elektrischen Schaltung vorgesehen ist.

Um eine einwandfreie Funktion von elektronischen Einrichtungen zu gewährleisten, ist es erforderlich, diese gegenüber Störstrahlungen, welche insbesondere im Hochfrequenzbereich auftreten, abzuschirmen. Solche Entstörmaßnahmen werden auf einer, im Inneren des elektronischen Gerätes befindlichen Leiterplatte vorgenommen, in dem ein Kondensator mit Leitungs- und Massepotential verbunden ist. Üblicherweise werden zur Entstörung in Metallgehäuse eingelötete Standard-Kondensatoren benutzt, welche teuer und aufwendig in der Verarbeitung sind.

Der Erfindung liegt somit die Aufgabe zugrunde, eine einfache und billige Entstörmaßnahme für elektronische Geräte anzugeben, welche auch für die Massenproduktion geeignet sind.

Erfindungsgemäß wird die Aufgabe dadurch gelöst, dass das Steckelement selbst als Kondensator ausgebildet ist.

Die Erfindung hat den Vorteil, dass die Entstörung bereits auf der Außenseite des elektronisches Gerätes erfolgt und Störstrahlungen gar nicht erst in das Gehäuseinnere gelangen.

Vorteilhafterweise weist das Steckelement eine elektrisch leitende Hülse auf, welche ein elektrisch leitenden, die Hülse ins Gehäuseinnere überragenden Stift beabstandet umschließt, wobei der Raum zwischen Hülse und Stift mit einem Dielektrikum ausgefüllt ist und die Metallhülse mit einem ersten elektrischen Potential und der Stift mit einem zweiten elektrischen Potential verbunden ist. Aufgrund dieser Ausgestaltung entfällt ein Montageschritt bei der Herstellung des elektronisches Gerätes, da der Stecker die Entstörkondensatoren bereits beinhaltet.

Auf zusätzliche Befestigungseinrichtungen am Gehäuse kann verzichtet werden, wenn die Hülse und ein Steckerkörper der Kontakteinrichtung einstückig aus elektrisch leitendem Material hergestellt sind.

In einer bevorzugten Ausführungsform ist die Hülse elektrisch mit dem Gehäusepotential verbunden. Dies wird vorteilhafterweise dadurch erreicht, dass die Hülse am Gehäuse an- und/oder aufliegt.

Eine besonders einfache Methode der Herstellung der Verbindung mit dem Gehäusepotential besteht darin, dass die Hülse kraft- und/oder formschlüssig in das Gehäuse eingesetzt ist. Die Montage des gesamten Steckers reduziert sich auf einen einzigen Einpressvorgang für die Signal- und Gehäusekontakte, wenn die Hülse an ihrer Oberfläche in eine Gehäuseöffnung eingreifende Mittel, vorzugsweise Rastmittel zur Verankerung aufweist.

Die Kondensatoren stellen gemeinsam mit der Steckeinrichtung eine bauliche Einheit dar, wenn die Hülse mehrere Stifte umschließt.

Vorteilhafterweise ist der Stift als Einpresskontakt für die elektronische Schaltung ausgebildet, wobei dieser Kontakt sofort mit der Montage des Steckers hergestellt wird.

Aufgrund der Ausgestaltung des Steckers als Kondensator ist es möglich, dass das elektrische Gerät aus einem elektrisch leitfähigem, aber nicht lötbaren Außengehäuse besteht, wobei das Gehäuse in einem Aluminium-DruckgussVerfahren herstellbar ist.

Die Erfindung lässt zahlreiche Ausführungsformen zu. Eine davon soll anhand der in der Zeichnung dargestellten Figur näher erläutert werden. Es zeigt:
- Fig. 1: Schnitt durch ein Steuergerät mit einer ersten Ausführungsform der erfindungsgemäßen Steckereinrichtung,
- Fig. 2:: zweite Ausführungsform der Steckeinrichtung

Gleiche Merkmale sind mit gleichen Bezugszeichen gekennzeichnet.

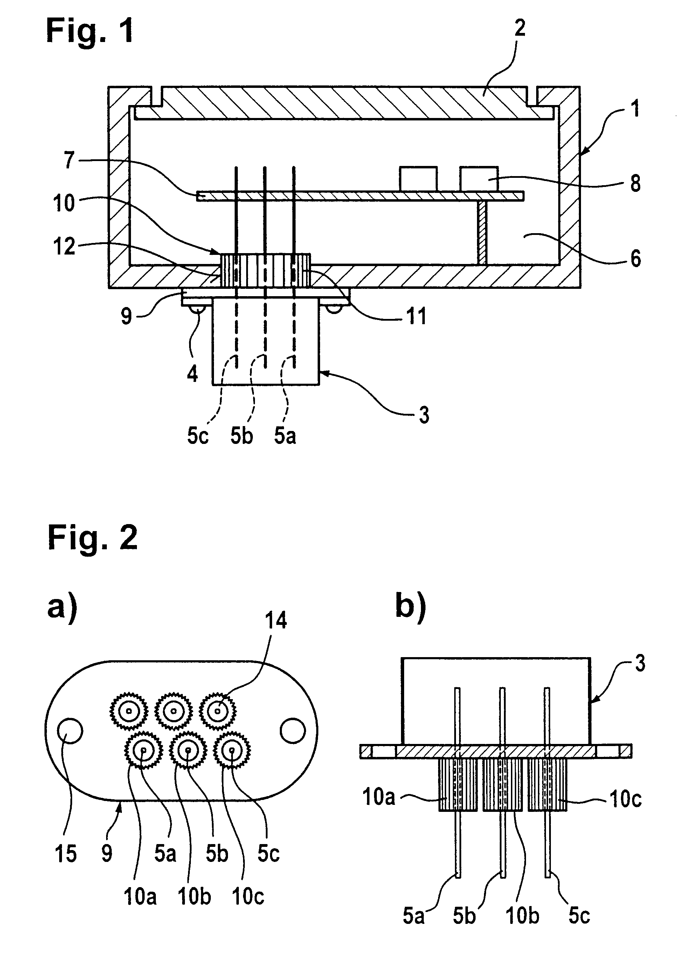

In Figur 1 ist ein elektrisches Gerät dargestellt, wie es üblicherweise in Kraftfahrzeugen Anwendung findet. Dabei kann es sich um ein Steuergerät eines Kraftfahrzeuges handeln, welches eine signalverarbeitende Elektronik aufweist, die bekanntlicherweise sehr störanfällig gegenüber hohen Frequenzen ist. Es ist aber auch vorstellbar, dass das elektronische Gerät eine Sensoreinrichtung darstellt, welche neben einem eigentlichen Sensor eine Signalaufbereitungsschaltung und/oder eine Signalauswerteschaltung aufweist, die auf einer oder mehreren Leiterplatten angeordnet sind.

Das elektronische Gerät besitzt ein aus Aluminium bestehendes becherförmiges Gehäuseteil 1, welches mit einer Abdeckung 2 verschlossen ist. Das becherförmige Gehäuseteil 1 weist einen Steckerkörper 3 auf, welcher am Gehäuseteil 1 mittels Schrauben oder Nieten 4 außenseitig befestigt ist. Die Steckerpins 5 des Steckerkörpers 3 ragen sowohl in den Steckerkörper 3 als auch in das Gehäuseinnere 6. Der Stecker 3 verbindet über die Steckerpins 5 die Schaltung des Gerätes mit anderen elektrischen und elektronischen Einrichtungen im Kraftfahrzeug.

Im Gehäuseinneren 6 ist zumindest eine Leiterplatte 7 angeordnet, welche Bauelemente 8 trägt, die die elektronischen Schaltungen realisieren. Die in das Gehäuseinnere 6 hineinragenden Steckerpins 5 sind elektrisch zur Zuführung von Signalen und elektrischer Leistung mit dem auf der Leiterplatte 7 befindlichen Bauelement 8 verbunden. In eine Steckerfläche 9, die auf der Außenseite des Gehäuseteiles aufliegt, ist eine Metallhülse 10 angeordnet, welche die Steckerpins 5 partiell umschließt. Diese Metallhülse 10 weist außenseitig an ihrem Umfang Vorsprünge auf, die vorzugsweise als Riefen ausgebildet sind. Diese Riefen ermöglichen das Einpressen und Befestigen des Steckers 3 in eine Gehäuseöffnung 12. Dabei kann auf die Schrauben zur Befestigung des Steckers 3 am Gehäuse verzichtet werden. Die Steckerpins 5a, 5b, 5c sind in die, die elektronische Schaltung tragende Leiterplatte 7 eingepresst. Dies erfolgt in einem Montageschritt mit dem Einfügen des Steckers 3 in das Gehäuse 1.

In Figur 2 ist eine andere Ausführungsform des erfindungsgemäßen Steckers dargestellt. An der den Steckerboden bildenden Steckerfläche 9 sind verschiedene Steckerstifte 5a, 5b, 5c angeordnet, wobei jeder Steckerstift 5a, 5b, 5c jeweils von einer eigenen Metallhülse 10a, 10b, 10c umfasst ist. Zwischen dem jeweiligen Steckerstift und der zugehörigen Metallhülse ist ein Abstand vorhanden, welcher mit einem Dielektrikum ausgefüllt ist. Wie in Figur 2b ersichtlich sind die Hülsen 10a, 10b, 10c nur partiell über den jeweiligen Steckerstift 5a, 5b, 5c gezogen. Diese bilden somit einen Durchführungskondenstor.

Werden die Hülsen 10a, 10b, 10c sowie der Steckerkörper 3 einstückig aus elektrisch leitendem Material hergestellt, entfällt die Notwendigkeit die Notwendigkeit der Befestigung der Steckereinheit über die Löcher 15.

Die erfindungsgemäße Anordnung dient zum Schutz einer z. B. in einem Aluminium-Druckguss- Gehäuse innenliegenden Elektronik gegen hochfrequente Störstrahlung.

## Patentansprüche

1. Elektronisches Gerät mit einer an einem elektrisch leitendem Gehäuse befestigten Kontakteinrichtung, welche mindestens ein Steckelement zur elektrischen Kontaktierung einer in dem Gehäuse angeordneten elektrischen Schaltung aufweist, wobei ein Kondensator zur Verbesserung der elektromagnetischen Empfindlichkeit der elektrischen Schaltung vorgesehen ist, **dadurch gekennzeichnet, dass** das Steckelement (5a, 10a; 5b, 10b; 5c, 10c) als Kondensator ausgebildet ist.

2. Elektronisches Gerät nach Anspruch 1, **dadurch gekennzeichnet, dass** das Steckelement (5a,10a; 5b, 10b; 5c, 10c) eine elektrisch leitende Hülse (10a, 10b, 10c) aufweist, welche eine elektrisch leitenden, die Hülse (10a, 10b, 10c) ins Gehäuseinnere (6) überragenden Stift (5a, 5b, 5c) beabstandet umschließt, wobei der Raum zwischen Hülse (10a, 10b, 10c) und Stift (5a, 5b, 5c) mit einem Dielektrikum (14) ausgefüllt ist, und die Metallhülse (10a, 10b, 10c) mit einem ersten elektrischen Potential und der Stift (5a, 5b, 5c) mit einem zweiten elektrischen Potential verbunden ist.

3. Elektronisches Gerät nach Anspruch 1 und 2 **dadurch gekennzeichnet, dass** die Hülse (10a, 10b, 10c) und ein Steckerkörper (3) der Kontakteinrichtung einstückig aus elektrisch leitendem Material hergestellt sind.

4. Elektronisches Gerät nach Anspruch 2, **dadurch gekennzeichnet, dass** die Hülse (10a, 10b, 10c) elektrisch mit dem Gehäusepotential verbunden ist.

5. Elektronisches Gerät nach Anspruch 4, **dadurch gekennzeichnet, dass** die Hülse (10a, 10b, 10c) am Gehäuse (1) an- oder aufliegt.

6. Elektronisches Gerät nach Anspruch 5, **dadurch gekennzeichnet, dass** die Hülse (10a, 10b, 10c) kraft- und/oder formschlüssig in das Gehäuse (1) eingesetzt ist.

7. Elektronisches Gerät nach Anspruch 6, **dadurch gekennzeichnet, dass** die Hülse (10) an ihrer Oberfläche in eine Gehäuseöffnung (12) eingreifende Mittel (11), vorzugsweise Rasteinrichtungen zur Verankerung aufweist.

8. Elektronisches Gerät nach Anspruch 2, **dadurch gekennzeichnet, dass** die Hülse (10) mehrere Stifte (5a, 5b, 5c) umschließt.

9. Elektronisches Gerät nach Anspruch 2, **dadurch gekennzeichnet, dass** der Stift (5a, 5b, 5c) als Einpresskontakt für die elektrische Schaltung ausgebildet ist.

10. Elektronisches Gerät nach einem der vorhergehenden Ansprüche, **dadurch gekennzeichnet, dass** das Gehäuse (1) aus einem Aluminium-Druckguss gebildet ist.
